# EUROPÄISCHE PATENTANMELDUNG

(11) **EP 0 930 443 A2**
(43) Veröffentlichungstag der Anmeldung: **21.07.1999**
(21) Anmeldenummer: 99100588.5
(22) Anmeldetag: 14.01.1999
(51) Int. Cl.: F16C 7/06

(54) **Verfahren zum Herstellen eines hochbelastbaren Stabes sowie der nach dem Verfahren hergestellte Stab**

(30) Priorität: 14.01.1998 DE 19800911
(71) Anmelder: Deutsches Zentrum für Luft- und Raumfahrt e.V., 53175 Bonn (DE)
(72) Erfinder: Schütze, Rainer Dr., 38110 Braunschweig (DE)
(74) Vertreter: Einsel, Martin, Dipl.-Phys.

(57) **Zusammenfassung**

Bei einem Verfahren zum Herstellen eines hochbelastbaren Stabes (1), insbesondere Faserverbundstabes, mit einer rohrförmigen Wandung (70), konusförmigen Anschlußelementen (50, 60) und einem aktiven Element (10) erfolgt die Herstellung kontinuierlich oder quasi-kontinuierlich, indem das aktive Element in ein Hülsenelement (40) eingefügt, die Anschlußelemente (50, 60) beidseitig des Hülsenelementes (40) angeordnet und fixiert, harzgetränkte Fasem des Stabes auf dem Hülsenelement sowie auf den Anschlußelementen abgelegt und elektrische Speiseleitungselemente (14) des aktiven Elementes (10) angreifbar nach außen geführt werden.

## Beschreibung

Die Erfindung betrifft ein Verfahren zum Herstellen eines hochbelastbaren Stabes, insbesondere Faserverbundstabes mit einer rohrförmigen Wandung, konusförmigen Anschlußelementen und einem aktiven Element sowie einen nach dem Verfahren hergestellten Stab.

Stäbe aus Faserverbundwerkstoffen sind hochbelastbar und besitzen eine Reihe von Vorteilen. Beispiele sind aus der DE 41 35 695 C2 und der DE 195 24 080 C1 bekannt.

Aus der DE 43 10 825 C1 ist ein Faserverbundstab bekannt, dessen Länge durch ein aktives Element, insbesondere einen Piezo-Aktuator veränderbar ist. Als aktive Elemente werden hierbei aktiv steuerbare, druckerzeugende Elemente bezeichnet, die längenveränderbar sind, durch entsprechende Ansteuerung. Der Stab besteht aus zwei Stabhälften, welche mittels einer Hülse miteinander verbunden sind.

Eine derartige Hülse ist auch aus der DE 44 19 691 C1 bekannt. Zwischen den Stabenden ist der Piezo-Aktuator eingefügt, der beide Stabhälften auseinanderdrückt, sofern eine entsprechende elektrische Spannung an ihm angelegt wird. Die Hülse ist auf die beiden Stabhälften aufgeklebt. Sie wirkt als Feder, deren Steifigkeit durch entsprechendes Fasermaterial sowie durch entsprechende Wanddicke einstellbar ist. Es hat sich aber gezeigt, daß durch die geklebte Muffenverbindung (beide Stabhälften verbunden durch die Hülse) die Schwingfestigkeit des Stabes begrenzt ist und der Fertigungsaufwand für den Stab verhältnismäßig groß ist.

Der Erfindung liegt daher die Aufgabe zugrunde, ein Verfahren zum Herstellen eines hochbelastbaren Stabes, insbesondere Faserverbundstabes, mit einer rohrförmigen Wandung, konusförmigen Anschlußelementen und einem aktiven Element sowie einen nach diesem Verfahren hergestellten Stab zu schaffen, bei welchem keine Klebeverbindung mehr erforderlich ist und der Fertigungsaufwand im Vergleich zum Stand der Technik geringer ist.

Die Aufgabe wird für ein Verfahren nach dem Oberbegriff des Anspruchs 1 dadurch gelöst, daß die Herstellung kontinuierlich oder quasi-kontinuierlich erfolgt, das aktive Element in ein Hülsenelement eingefügt wird, die Anschlußelemente beidseitig des Hülsenelementes angeordnet und fixiert werden, harzgetränkte Fasern des Stabes auf dem Hülsenelement sowie auf dem Anschlußelement abgelegt werden und elektrische Speiseleitungselemente des aktiven Elementes angreifbar nach außen geführt werden. Für einen Stab wird die Aufgabe dadurch gelöst, daß der Stab ein aktives Element, Anschlußelemente, ein Hülsenelement, eine rohrförmige Wandung mit konusförmigen Enden und elektrische Speiseleitungselemente aufweist. Weiterbildungen der Erfindung sind in den jeweiligen Unteransprüchen definiert.

Dadurch wird ein Verfahren zum Herstellen eines hochbelastbaren Stabes geschaffen, durch welches dieser hochbelastbare Stab, wie z.B. ein üblicher Kohlefaserverbundwerkstoff-Sandwichstab mit integrierten Krafteinleitungselementen, in einem quasikontinuierlichen Fertigungsprozeß hergestellt wird. Bekannt ist ein Verfahren, bei dem mehrere Kernstäbe (Stäbe mit Schaumkern) mit konischen Aluminiumgewinde- oder Anschlußelementen verklebt werden, was als Montageklebung bezeichnet wird. Im Anschluß daran werden die einzelnen Kernstäbe durch Gewindestifte zu einem Langstab miteinander verbunden, einer Fertigungseinheit zugeführt und mit unidirektionalen Fasern belegt.

Erfindungsgemäß wird zwischen den Anschlußelementen anstelle eines Stabes mit Schaumkernelement ein aktives Element, besonders bevorzugt ein Piezo-Aktuator sowie ein Druckstab, insbesondere ein Druckstab mit hoher Dehnsteifigkeit, eingefügt. Die Länge des Druckstabes ist abhängig von der Gesamtlänge des Stabes. Die Dimensionierung des aktiven Elementes ist dabei unabhängig von der Länge des Stabes. Wird ein kurzer Stab hergestellt, kann die Länge des dehnsteifen Druckstabes zu Null gewählt werden, dieser also völlig entfallen. Die Gewindeelemente sind vorzugsweise aus Aluminium gefertigt und weisen eine Konusform auf. Die beiden Anschlußelemente werden vorzugsweise mittels des aus einem Fasergewebeschlauch gefertigten Hülsenelementes zusammengehalten. Das Hülsenelement schützt das aktive Element, insbesondere den Piezo-Aktuator, und den inneren Druckstab gegen von außen eindringendes Laminierharz.

Auf dem Hülsenelement sowie auf den daran anliegenden Anschlußelementen werden die mit Harz getränkten Fasern des Stabes, besonders bevorzugt unidirektionalen Fasern des Stabes, abgelegt. Die Anschlußelemente sind an dem Hülsenelement aus insbesondere Faserverbundwerkstoff fixiert. Vorzugsweise geschieht diese Fixierung durch Montageklebungen, welche jedoch nach der Fertigstellung des Stabes keine Bedeutung mehr zeigen.

Zwischen dem aktiven Element, insbesondere dem Piezo-Aktuator, und dem ersten Anschlußelement ist ein Druckteller-Element mit einem Feingewinde angeordnet. Durch das Feingewinde ist ein Nachstellen des Druckteller-Elementes zum Vorbelasten des Stabes und des aktiven Elementes (Piezo-Aktuator) in Achsrichtung möglich. Zum Vorbelasten des Stabes wird eine durchbohrte Schraube vorgesehen, welche zum Befestigen des Stabes in einer Zugprüfmaschine geeignet vorgesehen ist. Durch die Schraube kann ein Innensechskant-Schlüssel geführt werden. Dieser greift dann in eines entsprechenden Innensechskant des Feingewindes des Druckfeller-Elementes ein. Die durchbohrte Schraube wird zum Befestigen des Stabes in einer Zugprüfmaschine verwendet. Zwischen dem aktiven Element (Piezo-Aktuator) und dem zweiten Anschlußelement (konusförmigem Gewindeelement) ist ein dehnsteifer Druckstab vorgesehen, welcher mit einem weiteren Druckteller-Element zur besseren Krafteinleitung in diesem Bereich versehen ist. Besonders bevorzugt werden die konisch zulaufenden Stabenden auf ihren Außenseiten zusätzlich mit einer Faserringwicklung mit hoher Faserfestigkeit versehen.

Besonders bevorzugt kann die Federsteifigkeit des Stabes durch Änderung seiner Länge, seines Querschnittes sowie seines Fasermaterials eingestellt bzw. variiert werden, da das in den Stab eingefügte aktive Element, insbesondere der Piezo-Aktuator, diesen gesamtheitlich dehnt.

Vorzugsweise werden die Enden der elektrischen Speiseleitungselemente, insbesondere die beiden elektrischen Kabel des Piezo-Aktuators, entweder durch die rohrförmige Wandung des Stabes oder durch die insbesondere metallischen konusförmigen Anschlußelemente (mit Gewinde) sowie die aufgefügten Druckkappen nach außen geführt. Sie treten dann seitlich aus dem Druckstab aus. Um eine Möglichkeit zu schaffen, die sich im Inneren des Hülsenelementes aus insbesondere Faserverbundwerkstoff befindlichen Enden (Kabelenden) an der Oberfläche des Stabes wiederfinden zu können, wenn die Herausführung aus der rohrförmigen Wandung gewünscht ist, wird entweder die Lage der miteinander verbundenen Enden der elektrischen Speiseleitungselemente bezüglich Markierungen an der Stirnseite der Anschlußelemente exakt bestimmt. Eine von außen eingebrachte Bohrung durch die Stabwandung trifft dann diese Enden (Kabelenden) genau. Die Kabelenden können aber auch an einem biegesteifen länglichen Element, insbesondere einem steifen Draht, befestigt werden. Dieser drückt vorzugsweise mit leichter Federspannung durch eine mit einem Folienteil abgedeckte Bohrungsöffnung innerhalb des Hülsenelementes nach außen. Nach dem Fertigungsprozeß kann dadurch in der unidirektionalen Faserschicht des Stabes eine kleine, sichtbare Wulst wahrgenommen werden.

Durch die durch die Wandung des kräfteführenden Stabes geführten elektrischen Speiseleitungselemente erfolgt eine Schwächung dieses Durchführungsbereiches. Dieser kann entgegengewirkt werden, bevorzugt dadurch, daß unidirektional ausgerichtete Fasern im Bereich dieser Durchführungen zur Verstärkung eingebracht werden. Vorzugsweise werden die unidirektionalen Fasern auf der Innenseite des Hülsenelementes aus Faserverbundwerkstoff angebracht. Hierbei genügen bereits wenige unidirektionale Fasern, um die Schwächung zu kompensieren. Einfacher ist jedoch das Herausführen durch das konusförmige Anschlußelement und eine aufgefügte Druckkappe, da diese aus Metall bestehen.

Bei dem erfindungsgemäß ausgestalteten und hergestellten, also bereits während seiner Fertigung mit einem aktiven Element versehenen Faserverbundstab sind besonders vorteilhaft die lasttragenden unidirektionalen Fasern der Stabwandung nicht unterbrochen, wie dies sich als nachteilig beim Stand der Technik erwiesen hat, da dabei eine Schwachstelle geschaffen wird.

Von besonderem Vorteil bei den erfindungsgemäßen Stäben ist, daß die Fertigung sehr viel einfacher und kostengünstiger auch in großen Stückzahlen erfolgen kann.

Die Federsteifigkeit wird verbessert, der Formschluß anstelle der Klebung schafft weitere Vorteile.

Die Kabel verlassen den Stab ohne Schwächung und Störung der Außenhaut. Gerade die kräfteführende Schicht wird nicht unterbrochen.

Schließlich ist auch der Sicherheitsaspekt zu berücksichtigen. Auch dann, wenn das Piezoelement ausfällt und keinen Beitrag mehr liefert, verbleibt der Stab als nach wie vor haltendes, stabiles und im übrigen funktionstüchtiges Element, das erst bei einer folgenden Routineinspektion der Gesamtkonstruktion ohne jede Hast ausgewechselt werden muß.

Zur näheren Erläuterung der Erfindung wird im folgenden ein Ausführungsbeispiel anhand der Zeichnungen beschrieben.

Diese zeigen in:
- **Figur 1**: eine Schnittansicht durch eine Ausführungsform eines erfindungsgemäßen hochbelastbaren Faserverbundstabes,
- **Figur 2 - Figur 6**: prinzipieller Verfahrensablauf des Zusammensetzens bzw. Herstellens des Stabes gemäß Figur 1 in einzelnen Verfahrensschritten, und
- **Figur 7**: eine Detailansicht des Stabes gemäß Figur 6.

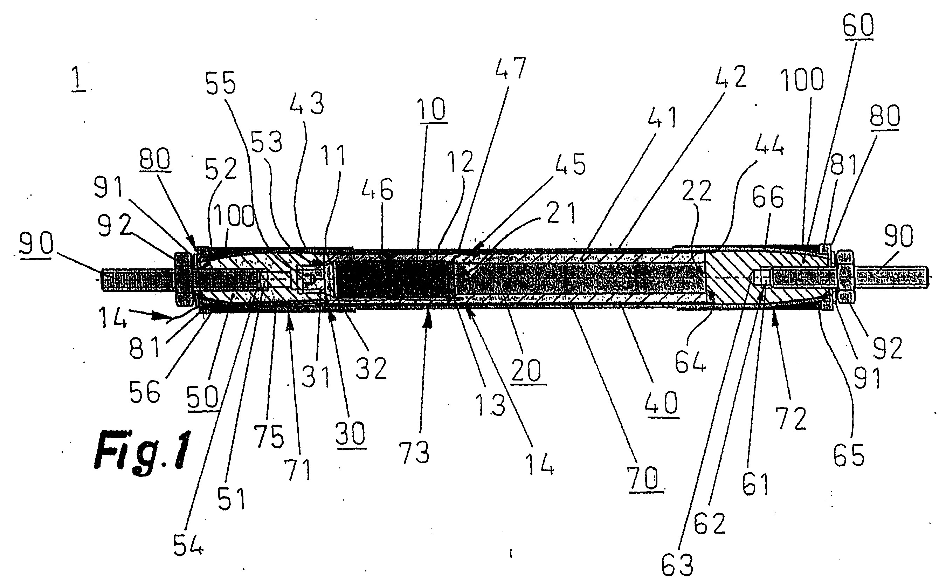

In **Figur 1** ist eine Schnittansicht eines erfindungsgemäßen Stabes 1 dargestellt. Der Stab weist ein piezoelektrisches Element 10 auf. Anstelle eines piezoelektrischen Elementes kann auch ein Körper aus einer Legierung mit Formgedächtnismaterial verwendet werden. Das piezoelektrische Element 10 ist in seiner Länge abhängig von einer an elektrischen Kabeln 14 anliegenden Spannung veränderbar. Dadurch kann auch der Stab in seiner Länge verändert werden.

Zu diesem Zweck ist das piezoelektrische Element 10 an seinem ersten Ende 11 mit einem Druckfeller-Element 30 verbunden. Das Druckfeller-Element 30 weist ein konisches Teilstück 32 auf, welches sich an dem Ende 11 anlagert. Ebenso weist das Druckteller-Element 30 ein Gewindeteilstück 31 auf, welches insbesondere mit dem konischen Teilstück 32 einstückig ist. Das Gewindeteilstück weist sowohl ein Außengewinde als auch eine zentrale Bohrung mit Innengewinde auf.

An dem zweiten Ende 12 des piezoelektrischen Elementes 10 ist eine Druckscheibe 13 angeordnet. Auf der anderen Seite der Druckscheibe lagert ein Druckstab 20 mit seinem ersten Ende 21 an. Dieser Druckstab weist vorzugsweise eine hohe Dehnsteifigkeit auf. Das piezoelektrische Element ist also zwischen zwei Druckelementen, nämlich der Druckscheibe 13 mit nachfolgendem Druckstab 20 und dem Druckteller-Element 30 angeordnet. Die von dem piezoelektrischen Element ausgehenden Druckkräfte werden dadurch unmittelbar in die entsprechenden Druckelemente eingeleitet.

Das konische Teilstück 32 des Druckteller-Elementes 30, das piezoelektrische Element 10, die Druckscheibe 13 und der Druckstab 20 werden bis zu dessen zweiten Ende 22 von einem Hülsenelement 40 ummantelt. Das Hülsenelement 40 weist eine Schaumfüllung 41 auf, welche von einem Fasergewebeschlauch 42 umgeben ist. Durch den Fasergewebeschlauch 42 werden piezoelektrisches Element und innerer Druckstab gegen von außen eindringendes Laminierharz geschützt, welches ansonsten bei dem weiter unten geschilderten Belegen mit harzgetränkten Fasern auftreten könnte.

An dem ersten Ende 43 des Hülsenelementes 40 ist ein rotationssymmetrisches Anschlußelement 50 angelagert. An dem zweiten Ende 44 des Hülsenelementes 40 ist ein rotationssymmetrisches Anschlußelement 60 angefügt. Das Anschlußelement 50 ist beispielsweise aus Aluminium hergestellt. Es weist eine zentrale Durchgangsöffnung 51 auf. Von dem ersten Ende 52 des Anschlußelementes aus ist die Durchgangsöffnung 51 mit einem Gewindeteilstück 54 versehen. Auch von dem zweiten Ende 53 des Anschlußelementes 50 aus ist die Durchgangsöffnung 51 mit einem Gewindeteilstück 55 versehen. Das gesamte Anschlußelement 50 ist vorzugsweise von außen mit einer achsparallelen unidirektionalen Faserummantelung 56 versehen.

Das Anschlußelement 60 weist ebenfalls eine zentrale Bohrung als koaxiale Gewindebohrung 61 mit einem Gewinde 62 und einem Sackloch 63 auf. Die koaxiale Gewindebohrung 61 ragt von dem zweiten Ende 65 des Anschlußelementes 60 etwa zwei Drittel bis zu dem ersten Ende 64 des Anschlußelementes 60. Auch das Anschlußelement 60 ist mit einer achsparallelen unidirektionalen Faserummantelung 66 versehen.

Die gesamte Anordnung aus Anschlußelementen 50, 60, Druckteller-Element 30, Druckstab 20 und piezoelektrischem Element 10 ist vollständig umhüllt von einer rohrförmigen Wandung 70 aus Faserverbundmaterial. Vorzugsweise besteht die rohrförmige Wandung 70 aus mit Harz getränkten unidirektionalen Fasern. Die rohrförmige Wandung 70 weist ein mittleres zylinderförmiges Teilstück 73 und beidseitig außen konusförmige Enden 71, 72 auf.

Zum Durchführen der elektrischen Kabel 14 des piezoelektrischen Elementes 10 sind sowohl in dem metallischen konusförmigen Anschlußelement 50, 60 als auch in der metallischen Druckkappe 80 Durchgangsöffnungen 75 vorgesehen. Die Druckkappe weist einen seitlichen Austritt für die elektrischen Kabel 14 auf. Zum Verstärken der Schwächung des Hülsenelementes 40 bei alternativem Vorsehen von Durchführungsöffnungen in diesem Bereich sind an den Durchführöffnungen 45 von der Innenseite 46 des Hülsenelementes 40 unidirektionale Fasern 47 aufgebracht.

Die Enden des mit der rohrförmigen Wandung 70 ummantelten Stabes werden von den Druckkappen 80 abgedeckt. Diese umgreifen die Enden mit ihrem Kragen 81. Auf der Außenseite der Druckkappen 80 sind Scheiben 91 angeordnet. Diese dienen als Auflagerfläche für eine jeweilige Arretierungsmutter 92 eines Anschlußteiles 90, welches in die zentrale Bohrung 61 bzw. die Durchgangsöffnung 51 der beiden Anschlußelemente eingeschraubt sind. Die Anschlußteile 90 dienen zum Verbinden mit einem jeweiligen weiteren Element, an dem der hochbelastbare Stab 1 angeschlossen werden soll. Die konusförmigen Enden 71, 72 der rohrförmigen Wandung 70 sind jeweils zusätzlich von außen mit einer Faserringwicklung 100 umwickelt. Die Druckkappen 80 dienen dabei jeweils als Begrenzungswand des Wickelraumes für die Faserringwicklungen. Dadurch sind diese mit der Faserringwicklung und dem jeweiligen Stabende dauerhaft verbunden, wodurch sie einen integralen Bestandteil des Stabes bilden. Beispielsweise wird der Stab zum Aufbringen der Faserringwicklungen drehbar gelagert und mit einem Drehantrieb versehen. Zum Schaffen dieser drehbaren Lagerung kann beispielsweise das jeweilige Anschlußteil 90 in einen entsprechenden Drehantrieb eingeschraubt werden.

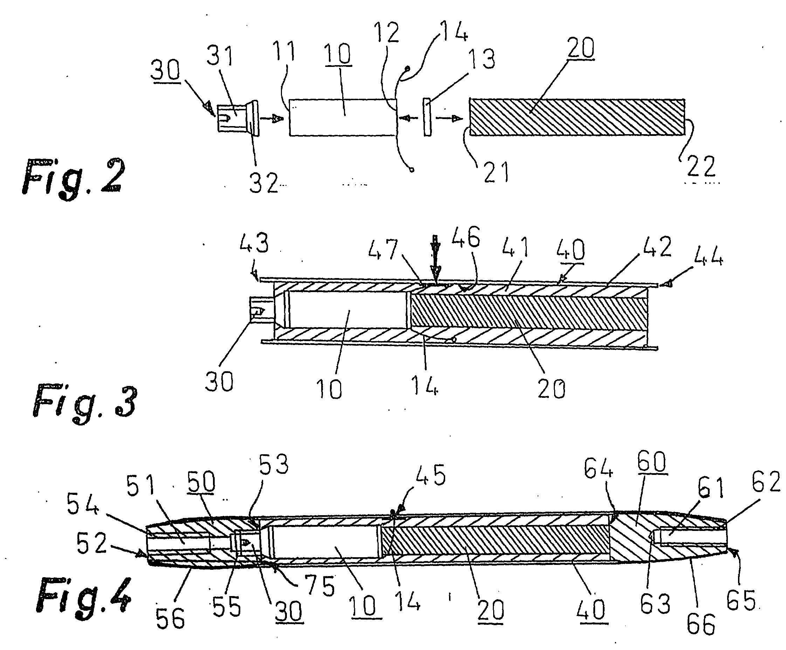

Die folgenden **Figuren 2 bis 6** zeigen jeweils die einzelnen Verfahrensabschnitte zum Herstellen des in Figur 1 dargestellten Stabes. In Figur 2 ist dabei zunächst das Zusammenfügen des piezoelektrischen Elementes 10, der Druckscheibe 13, des Druckstabes 20 und des Druckteller-Elementes 30 dargestellt. Das Druckteller-Element 30 wird mit seinem konischen Teilstück 32 gegen das erste Ende 11 des piezoelektrischen Elementes 10 angefügt und mit diesem fest verbunden. Dies geschieht vorzugsweise reibschlüssig.

An dem zweiten Ende 12 des piezoelektrischen Elementes 10 wird die Druckscheibe 13 angefügt. Auf ihrer anderen Seite wird der Druckstab mit seinem ersten Ende 21 angefügt.

Im Anschluß an dies Aneinanderfügen wird gemäß Figur 3 das Hülsenelement 40 so über die Anordnung geschoben bzw. gefügt, daß der Fasergewebeschlauch 42 an den beiden Ende 43, 44 des Hülsenelementes 40 übersteht. In diesen Bereich der Überstände greift nachfolgend das jeweilige Anschlußelement 50 bzw. 60 ein.

Wie in Figur 4 skizziert, werden anschließend die Anschlußelemente 50, 60 an beiden Enden 43, 44 des Hülsenelemente 40 angeordnet. Vorzugsweise werden sie angeklebt. Das Anschlußelement 50 wird dabei auf das Gewindeteilstück 31 des Druckteller-Elementes 30 aufgeschraubt. Es kann auch zum Fixieren von Hülsenelement 40 und Anschlußelementen 50, 60 zusätzlich eine Montageklebung erfolgen. Diese dient jedoch nicht dem Zweck, den Stab beim späteren Gebrauch hinsichtlich seiner Festigkeit in irgendeiner Weise zu unterstützen oder zu verstärken.

Das Druckteller-Element 30 weist vorzugsweise ein Feingewinde auf. Zum Vorbelasten des Stabes und des piezoelektrischen Elementes wird in Achsrichtung mit Hilfe des Druckteller-Elementes 30 eine Nachstellung vorgenommen. Zu diesem Zweck wird zum Befestigen des Stabes in einer Zugprüfmaschine eine durchbohrte Schraube verwendet, wie sie in Figur 4 nicht dargestellt ist. Durch diese Schraube kann beispielsweise ein Innensechskantschlüssel geführt werden, welcher einen der Innensechskant-Öffnung des Feingewindeteilstücks 31 entsprechenden Innensechskant aufweist.

Der Druckstab 20 ist vorzugsweise dehnsteif. Die zwischen dem Druckstab 20 und dem piezoelektrischen Element 10 vorgesehene Druckscheibe 13 dient einer besseren Krafteinleitung von Element 10 in den Druckstab 20.

Die beiden aus insbesondere Aluminium bestehenden Anschlußelemente 50, 60 sind, wie dargestellt, mit den jeweiligen Enden 52 bzw. 65 nach außen angeordnet.

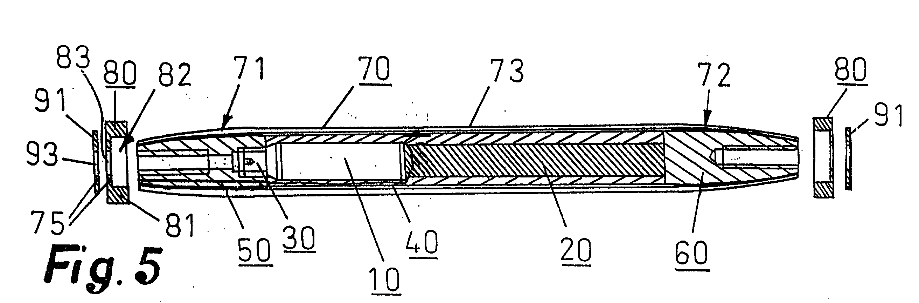

Wie in Figur 5 dargestellt, wird anschließend eine Ummantelung durch Ablegen von Fasern oder einem Fasergewebe auf der gesamten Anordnung als rohrförmige Wandung 70 vorgesehen. Die Fasern sind vorzugsweise bereits mit Harz vorgetränkt, wodurch eine kompakte Einheit nach dem Aushärten des Harzes entsteht.

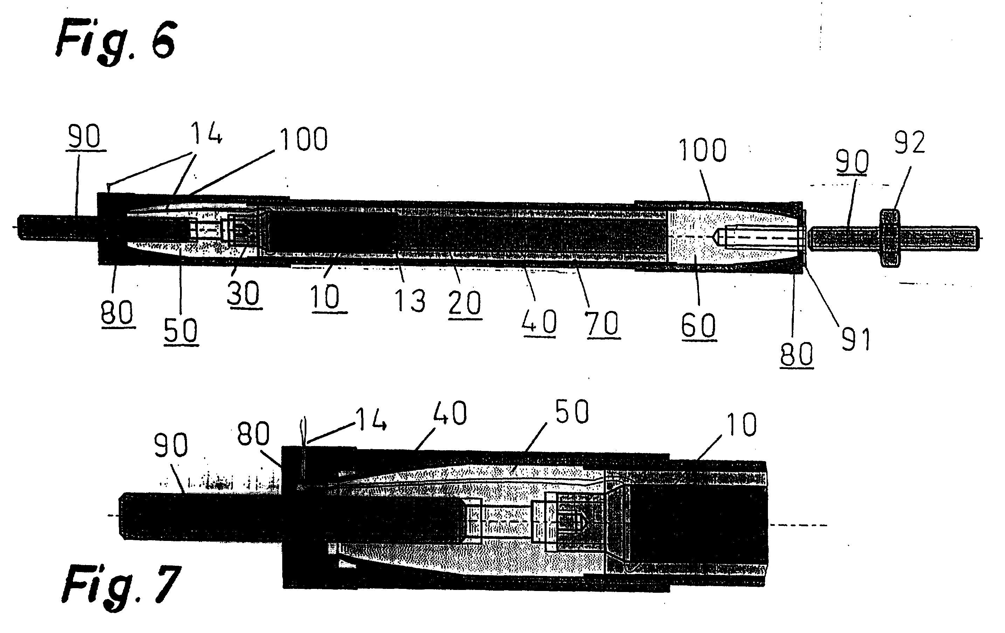

Die Durchführöffnung 75 zum Durchführen der elektrischen Kabel 14 des piezoelektrischen Elementes 10 wird, wie bereits oben geschildert, vorgesehen. Sie ist in Figur 6 in der Ausführungsform des Herausführens im Bereich der Anschlußelemente und Druckkappen.

Zum Verbinden mit den Anschlußteilen 90 (siehe auch Figur 6) werden auf die Enden der rohrförmigen Wandung mit den darunter angeordneten Anschlußelementen 50, 60 die Druckkappen 80 aufgefügt. Die Kragen 81 der beiden Druckkappen umgeben dabei von außen die jeweiligen Enden der rohrförmigen Wandung 70, wobei der Endbereich jeweils in einer Ausnehmung 82 der beiden Druckkappen 80 aufgenommen wird.

Die beiden Druckkappen 80 weisen zudem eine zentrale Öffnung 83 auf, durch welche später die Anschlußteile 90 durchgesteckt oder geschraubt werden können. Die auf der Außenseite der Druckkappen 80 angefügten Scheiben 91 weisen ebenfalls jeweils eine Öffnung 93 zum Durchführen der Anschlußteile 90 auf.

Figur 6 zeigt im linken Bereich ein bereits in das Anschlußelement 50 teilweise eingeschraubtes Anschlußteil 90, wohingegen auf der rechten Seite das Anschlußteil 90 noch nicht in das Anschlußelement 60 eingeschraubt ist. Zum Kontem der in die jeweiligen Anschlußelemente 50, 60 eingeschraubten Anschlußteile 90 werden die Arretierungsmuttern 92 gegen die Außenflächen der Scheiben 91 geschraubt.

Vorzugsweise vor dem Einschrauben der Anschlußteile 90 werden die Faserringwicklungen 100 auf den konusförmigen Enden der rohrförmigen Wandung 70 abgelegt. Vorzugsweise weisen die Faserringwicklungen eine besonders hohe Faserfestigkeit auf.

Die Federsteifigkeit des gesamten Stabes ergibt sich dann aus seiner Länge, seinem Querschnitt sowie seinem Fasermaterial. Vorzugsweise wird als Material für die Fasern Kohlefaserverbundwerkstoff verwendet.

Da an keiner Stelle - außer bei den Montageklebungen - eine Verklebung verwendet wird, kann ein erfindungsgemäß hergestellter hochbelastbarer Faserverbundstab sogar passiv überbelastet werden. Beispielsweise kann zu Testzwecken an dem Stab eine Zugkraft von 5 t angreifen. Der in dem Stab angeordnete Aktuator in Form des piezoelektrischen Elementes 10 nimmt dabei keinen Schaden, da die Zugkraft nicht direkt an ihm angreift, sondern von ihm abgekoppelt ist. Als besonders vorteilhaft erweist es sich, daß die lasttragenden unidirektionalen Fasern der rohrförmigen Wandung des Stabes nicht, wie dies bei beispielsweise einer späteren Integration des piezoelektrischen Elementes als aktivem steuerbarem Element geschieht, unterbrochen werden.

Aufgrund der Verwendung von Faserverbundwerkstoff und Aluminium wird weiterhin ein leichtbaugerechter Stab geschaffen. Dieser weist jedoch im Vergleich zu den bekannten Stäben eine sehr viel höhere Festigkeit auf und kann besonders gut in Serienfertigung hergestellt werden, da er, wie aus den Figuren 2 bis 6 zu entnehmen, kontinuierlich bzw. quasi-kontinuierlich hergestellt werden kann.

In **Figur 7** ist das Detail der aus der Druckkappe 80 herausgeführten Kabel 14 verdeutlicht.

### BEZUGSZEICHENLISTE

- 1: Stab

- 10: piezoelektrisches Element/Aktuator
- 11: Ende, erstes
- 12: Ende, zweites
- 13: Druckscheibe
- 14: elektrische Kabel

- 20: Druckstab
- 21: erstes Ende
- 22: zweites Ende

- 30: Druckteller-Element
- 31: Gewindeteilstück
- 32: konisches Teilstück

- 40: Hülsenelement
- 41: Schaumfüllung
- 42: Fasergewebeschlauch
- 43: erstes Ende
- 44: zweites Ende
- 45: Durchführöffnung
- 46: Innenseite
- 47: UD-Fasern

- 50: Anschlußelement, rotationssymmetrisch
- 51: Durchgangsöffnung
- 52: erstes Ende
- 53: zweites Ende
- 54: Gewindeteilstück

- 55: Gewindeteilstück
- 56: achsparallele UD-Faser-Ummantelung

- 60: Anschlußelement, rotationssymmetrisch
- 61: zentrale Bohrung, koaxiale Gewindebohrung
- 62: Gewinde
- 63: Sackloch
- 64: erstes Ende
- 65: zweites Ende
- 66: achsparallele UD-Faser-Ummantelung

- 70: rohrförmige Wandung
- 71: konusförmiges Ende
- 72: konusförmiges Ende
- 73: zylinderförmiges Teilstück

- 75: Durchgangsöffnung

- 80: Druckkappe
- 81: Kragen
- 82: Ausnehmung
- 83: Öffnung

- 90: Anschlußteil
- 91: Scheibe
- 92: Arretierungsmutter
- 93: Öffnung

- 100: Faserringwicklung

## Patentansprüche

1. Verfahren zum Herstellen eines hochbelastbaren Stabes (1), insbesondere Faserverbundstabes mit einer rohrförmigen Wandung (70), konusförmigen Anschlußelementen (50, 60) und einem aktiven Element (10), wobei die Herstellung kontinuierlich oder quasi-kontinuierlich erfolgt, das aktive Element in ein Hülsenelement (40) eingefügt wird, die Anschlußelemente (50, 60) beidseitig des Hülsenelementes (40) angeordnet und fixiert werden, harzgetränkte Fasern des Stabes auf dem Hülsenelement sowie auf den Anschlußelementen abgelegt werden und elektrische Speiseleitungselemente (14) des aktiven Elementes (10) angreifbar nach außen geführt werden.

2. Verfahren nach Anspruch 1,
**dadurch gekennzeichnet,**
**daß** das aktive Element (10) mit einem dehnsteifen Druckstab (20) vor dem Einfügen in das Hülsenelement (40) verbunden wird.

3. Verfahren nach Anspruch 1 oder 2,
**dadurch gekennzeichnet,**
**daß** die Enden der elektrischen Speiseleitungselemente (14) miteinander verbunden werden und ihre Lage in Bezug auf Markierungen an der Stirnseite der Anschlußelemente bestimmt wird.

4. Verfahren nach Anspruch 1 oder 2,
**dadurch gekennzeichnet,**
**daß** die Enden der elektrischen Speiseleitungselemente (14) an einem biegesteifen länglichen Element befestigt werden, wobei das biegesteife längliche Element eine vorbestimmbare Federspannung aufweist und dadurch eine mit einem Folienteil abgedeckte Bohrungsöffnung in dem Hülsenelement (40) nach außen gedrückt wird.

5. Verfahren nach einem der vorstehenden Ansprüche,
**dadurch gekennzeichnet,**
**daß** der geschwächte Durchführungsbereich (75) der durch die Wandung des kraftführenden Stabes geführten elektrischen Speiseleitungselemente (14) mittels unidirektional ausgerichteter Fasern (47) verstärkt wird.

6. Verfahren nach Anspruch 5,
**dadurch gekennzeichnet,**
**daß** die unidirektionalen Fasern (47) auf der Innenseite (46) des Hülsenelementes (40) aufgefügt werden.

7. Verfahren nach Anspruch 5 oder 6,
**dadurch gekennzeichnet,**
**daß** die Speiseleitungselemente (14) in Längsrichtung des Stabes durch das konische, mit Gewinde versehene Anschlußelement (50, 60) in eine angefügte Druckkappe (80) geführt werden, um seitlich aus dem Druckstab auszutreten.

8. Verfahren nach einem der vorstehenden Ansprüche,
**dadurch gekennzeichnet,**
**daß** zum Fixieren der Anschlußelemente (50, 60) auf dem Hülsenelement (40) erstere auf diesem verklebt werden.

9. Verfahren nach einem der vorstehenden Ansprüche,
**dadurch gekennzeichnet,**
**daß** der Stab (1) und das aktive Element (10) nach Einfügen eines Druckteller-Elementes (30) mit Feingewinde zwischen dem aktiven Element und dem ersten Anschlußelement (50) vorbelastet werden.

10. Verfahren nach einem der vorstehenden Ansprüche,
**dadurch gekennzeichnet,**
**daß** die Stabenden mit einer Faserringwicklung (100) umwickelt werden.

11. Stab, hergestellt mittels eines Verfahrens nach einem der Ansprüche 1 bis 10,
**dadurch gekennzeichnet,**
**daß** der Stab (1) ein aktives Element (10), Anschlußelemente (50, 60), ein Hülsenelement (40), eine rohrförmige Wandung (70) mit konusförmigen Enden (71, 72) und elektrische Speiseleitungselemente (14) aufweist.

12. Stab nach Anspruch 11,
**dadurch gekennzeichnet,**
**daß** ein Druckstab (20) vorgesehen ist, dessen Länge abhängig von der Gesamtlänge des Stabes (1) ist.

13. Stab nach Anspruch 11 oder 12,
**dadurch gekennzeichnet,**
**daß** der Druckstab (20) eine hohe Dehnsteifigkeit aufweist.

14. Stab nach Anspruch 11, 12 oder 13,
**dadurch gekennzeichnet,**
**daß** das Hülsenelement (40) ein ausgehärteter Fasergewebeschlauch ist.

15. Stab nach einem der Ansprüche 11 bis 14,
**dadurch gekennzeichnet,**
**daß** die rohrförmige Wandung (70) harzgetränkte unidirektionale Fasern aufweist.

16. Stab nach einem der Ansprüche 11 bis 15,
**dadurch gekennzeichnet,**
**daß** die Federsteifigkeit des Stabes durch Variation seiner Länge, seines Querschnittes sowie seines Materials, insbesondere des Fasermaterials, einstellbar oder veränderbar ist.

17. Stab nach einem der Ansprüche 11 bis 16,
**dadurch gekennzeichnet,**
**daß** zwischen aktivem Element (10) und dem ersten Anschlußelement (50) ein Druckteller-Element (30) mit Feingewinde zum Vorbelasten des Stabes und des aktiven Elementes vorgesehen ist.

18. Stab nach einem der Ansprüche 11 bis 17,
**dadurch gekennzeichnet,**
**daß** zwischen dem aktiven Element (10) und dem zweiten Anschlußelement (60) zur Krafteinleitung der dehnsteife Druckstab (20) und eine Druckscheibe (13) angeordnet sind.

19. Stab nach einem der Ansprüche 11 bis 18,
**dadurch gekennzeichnet,**
**daß** eine Faserringwicklung (100) mit hoher Faserfestigkeit auf den konischen Stabenden vorgesehen ist.

20. Stab nach einem der Ansprüche 11 bis 19,
**dadurch gekennzeichnet,**
**daß** unidirektionale Fasern (47) im Bereich der Durchführung der elektrischen Speiseleitungselemente (14) durch die Stabwandung (70) und das Hülsenelement (40) auf der Innenseite (46) des Hülsenelementes angeordnet sind.

21. Stab nach einem der Ansprüche 11 bis 20,
**dadurch gekennzeichnet,**
**daß** das aktive Element ein piezoelektrisches Element oder ein Element aus einer Legierung mit Formgedächnismaterial ist.
